# EUROPEAN PATENT APPLICATION

(11) **EP 4 769 895 A1**
(43) Date of publication of application: **01.07.2026**
(21) Application number: 25217452.9
(22) Date of filing: 20.11.2025
(51) Int. Cl.: H02J 7/60, B60L 3/00

(54) **DARK CURRENT DETECTION APPARATUS, BATTERY MANAGEMENT SYSTEM, AND BATTERY PACK**

(30) Priority: 31.12.2024 KR 20240201720
(71) Applicant: SAMSUNG SDI CO., LTD., Yongin-si, Gyeonggi-do 17084 (KR)
(72) Inventor: KIM, Hyun, 16678 Suwon-si (KR)
(74) Representative: Maiwald GmbH

(57) **Abstract**

A dark current detection apparatus, a battery management system, and a battery pack, having a circuit topology capable of detecting an increase in dark current due to the loss of a dark current blocking function of a dark current blocking element. A dark current detection apparatus can include a voltage monitoring circuit that outputs a voltage monitoring signal having a variable magnitude, the variable magnitude varying according to a monitoring voltage of a monitoring node connected to the dark current blocking element, and a processor that determines whether the dark current occurs based on the voltage monitoring signal output from the voltage monitoring circuit.

## Description

### BACKGROUND

### 1. Field

The present disclosure relates to a dark current detection apparatus, a battery management system, and a battery pack.

### 2. Description of the Related Art

As the demand for user convenience in vehicles continues to increase various electric systems for user convenience, such as an audio-video-navigation (AVN) device, a head-up display (HUD), a lamp device, an air conditioning device, and a wiper device, are being used in vehicles, and the number of electronic control circuits used in vehicles is also increasing for stable control and operation of vehicles and electric systems. As the number of electric systems and electronic control circuits (hereinafter, electrical loads) used in vehicles increases, the capacity and impedance characteristics of a low-voltage battery (e.g., a lead acid battery) for supplying operating power to the electrical loads have also been improved.

As various electrical loads are placed in vehicles user convenience has been greatly improved. However, the dark current of the low-voltage battery is greatly increasing due to the electrical loads, and this dark current is causing a decrease in the charge capacity of the low-voltage battery. The decrease in the charge capacity of the low-voltage battery may frequently cause complete discharge of the low-voltage battery, which may have a negative impact on user convenience. circuit

The above information disclosed in this Background section is for enhancement of understanding of the background of the present disclosure, and therefore, it may contain information that does not constitute related (or prior) art.

### SUMMARY

The present disclosure is directed to providing a dark current detection apparatus capable of detecting an increase in dark current due to loss of the dark current blocking function of a dark current blocking element, a battery management system, and a battery pack.

However, objects that the present disclosure intends to achieve are not limited to the above-described objects and other objects that are not described may be clearly understood by those skilled in the art from the following description.

To minimize discharge caused by the dark current of the low-voltage battery, a battery management system (BMS) is provided with a dark current blocking element that is connected to a circuit through which current is supplied from the low-voltage battery to loads and is configured to block the dark current.

According to an aspect of the present disclosure, there is provided a dark current detection apparatus including a voltage monitoring circuit that outputs a voltage monitoring signal having a variable magnitude, the variable magnitude varying according to a monitoring voltage of a monitoring node connected to a dark current blocking element, wherein the dark current blocking element is connected to a circuit through which current drawn from a battery is supplied to a load, wherein the dark current blocking element is configured to block a dark current drawn from the battery in a state in which the load is not driven, and a processor that activates the voltage monitoring circuit through an activation signal, wherein the processor determines whether the dark current occurs based on the voltage monitoring signal output from the activated voltage monitoring circuit.

According to the present disclosure, the dark current blocking element may include a first terminal and a second terminal, the first terminal corresponding to an input terminal of the battery and the second terminal corresponding to an output terminal of the battery, and the monitoring node may be a node connected to the second terminal.

According to the present disclosure, in a dark current detection mode (which can be defined as a state in which the load is not driven) where the load is not driven, the dark current blocking element blocks the dark current, the voltage monitoring circuit is activated through the activation signal, and the voltage monitoring circuit outputs a high-level voltage monitoring signal in response to an increase in the monitoring voltage, and the processor may determine that the dark current occurs due to loss of a dark current blocking function of the dark current blocking element when the high-level voltage monitoring signal is input from the voltage monitoring circuit.

According to the present disclosure, the voltage monitoring circuit may include a comparator that compares the monitoring voltage with a predefined reference voltage and outputs a comparison signal according to a comparison result, and a latch circuit that outputs a latched voltage monitoring signal having a latched variable magnitude according to the comparison signal output from the comparator.

According to the present disclosure, in the dark current detection mode, the comparator may output a high-level comparison signal when the monitoring voltage is greater than or equal to the predefined reference voltage, and the latch circuit may output a latched high-level voltage monitoring signal in response to the high-level comparison signal being output from the comparator.

According to the present disclosure, the voltage monitoring circuit may further include a compensation circuit that compensates for an abnormality of the voltage monitoring signal caused by an offset between a level transition time of the monitoring voltage and a level transition time of the activation signal based on an end time or entry time of the dark current detection mode.

According to the present disclosure, the compensation circuit may include a delay element that delays the level transition time of the monitoring voltage in order to compensate for the abnormality of the voltage monitoring signal caused by the offset between the level transition time of the monitoring voltage and the level transition time of the activation signal based on the end time of the dark current detection mode.

According to the present disclosure, the compensation circuit may further include a second delay element that delays the level transition time of the activation signal in order to compensate for the abnormality of the voltage monitoring signal caused by the offset between the level transition time of the monitoring voltage and the level transition time of the activation signal based on the entry time of the dark current detection mode.

According to the present disclosure, the dark current detection apparatus may further include an ignition circuit that controls activation of a dark current blocking operation of the dark current blocking element through a control signal, wherein the compensation circuit may further include a NOR gate that outputs a first intermediate signal through a NOR operation on the control signal and the activation signal, and an AND gate that outputs a second intermediate signal through an AND operation on the first intermediate signal and the comparison signal output from the comparator.

According to the present disclosure, the latch circuit may output the voltage monitoring signal having a variable magnitude according to the second intermediate signal.

According to the present disclosure, the control signal may follow an active-high mode, and the activation signal may follow an active-low mode.

According to the present disclosure, in the dark current detection mode, when the monitoring voltage is greater than or equal to the predefined reference voltage, a low-level control signal and a low-level activation signal may be input to the NOR gate and a high-level first intermediate signal may be output, a high-level comparison signal may be output from the comparator, the high-level comparison signal and the high-level first intermediate signal may be input to the AND gate and a high-level second intermediate signal may be output, and a high-level voltage monitoring signal may be output from the latch circuit and transmitted to the processor.

According to the present disclosure, when determining that the dark current has occurred through the voltage monitoring signal, the processor may notify an upper controller of the dark current and reset the latch circuit through a reset signal.

According to another aspect of the present disclosure, there is provided a battery management system including a dark current blocking element connected to a circuit through which current drawn from a battery is supplied to a load, the dark current blocking element configured to interrupt flow of the current and to block a dark current drawn from the battery in a shut-down mode of the BMS, a voltage monitoring circuit that outputs a voltage monitoring signal having a variable magnitude according to a monitoring voltage of a monitoring node connected to the dark current blocking element, and a processor that activates the voltage monitoring circuit through an activation signal in the shut-down mode of the BMS, wherein the processor determines whether the dark current occurs based on the voltage monitoring signal output from the activated voltage monitoring circuit.

According to the present disclosure, the battery management system may further include an ignition circuit which is activated at a time point when the BMS transitions from the shut-down mode to a wake-up mode, wherein the ignition circuit deactivates a dark current blocking operation of the dark current blocking element through a control signal, a constant power supply circuit that generates constant power for the BMS based on power supplied from the battery, wherein the voltage monitoring circuit may operate based on the constant power generated by the constant power supply circuit while the BMS is in the shut-down mode.

According to the present disclosure, the voltage monitoring circuit may include a comparator that compares the monitoring voltage with a reference voltage generated by the constant power supply circuit, wherein the comparator outputs a comparison signal according to a comparison result, and a latch circuit that outputs a voltage monitoring signal having a variable magnitude according to the comparison signal output from the comparator.

According to the present disclosure, in the shut-down mode of the BMS, the comparator may output a high-level comparison signal when the monitoring voltage is greater than or equal to the reference voltage, and the latch circuit may output a latched high-level voltage monitoring signal in response to the high-level comparison signal being output from the comparator.

According to the present disclosure, the voltage monitoring circuit may further include a first delay element that delays a level transition time of the monitoring voltage to compensate for an abnormality of the voltage monitoring signal caused by an offset between the level transition time of the monitoring voltage and a level transition time of the activation signal based on a time point at which the BMS transitions from the shut-down mode to the wake-up mode, a second delay element that delays the level transition time of the activation signal to compensate for the abnormality of the voltage monitoring signal caused by the offset between the level transition time of the monitoring voltage and the level transition time of the activation signal based on a time point at which the BMS transitions from the wake-up mode to the shut-down mode, a NOR gate that outputs a first intermediate signal through a NOR operation on the control signal and the activation signal, and an AND gate that outputs a second intermediate signal through an AND operation on the first intermediate signal and the comparison signal output from the comparator.

According to the present disclosure, in the shut-down mode of the BMS, when the monitoring voltage is greater than or equal to the reference voltage, a low-level control signal and a low-level activation signal may be input to the NOR gate and a high-level first intermediate signal may be output, a high-level comparison signal may be output from the comparator, the high-level comparison signal and the high-level first intermediate signal may be input to the AND gate and a high-level second intermediate signal may be output, and a high-level voltage monitoring signal may be output from the latch circuit and transmitted to the processor.

According to still another aspect of the present disclosure, there is provided a battery pack including a battery provided to supply operating power to a BMS, a dark current blocking element connected to a circuit through which current drawn from the battery is supplied to a load, the dark current blocking element configured to interrupt flow of the current and to block a dark current drawn from the battery in a shut-down mode of the BMS, a voltage monitoring circuit that outputs a voltage monitoring signal having a variable magnitude according to a monitoring voltage of a monitoring node connected to the dark current blocking element, and a processor that activates the voltage monitoring circuit through an activation signal in the shut-down mode of the BMS and determines whether the dark current occurs based on the voltage monitoring signal output from the activated voltage monitoring circuit.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure is not limited to the drawings, in which:
FIG. 1 is a block diagram of a dark current detection apparatus according to one embodiment;
FIG. 2 is a circuit diagram of an ignition circuit of the dark current detection apparatus according to one embodiment;
FIG. 3 is a circuit diagram of a dark current detection apparatus according to a first embodiment;
FIGS. 4 and 5 are examples for describing an offset between a level of a monitoring voltage and a level of an activation signal that occurs in the dark current detection apparatus according to the first embodiment;
FIG. 6 is a circuit diagram of a dark current detection apparatus according to a second embodiment; and
FIGS. 7 and 8 are timing diagrams for describing the operation of the dark current detection apparatus according to the second embodiment.

### DETAILED DESCRIPTION

Hereinafter, embodiments of the present disclosure will be described, in detail, with reference to the accompanying drawings. The terms or words used in this specification and claims are not limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, there may be various equivalents and modifications that can replace or modify the embodiments described herein at the timing of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections are not limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein includes all subranges of the same numerical precision subsumed within the recited range. For example, a range of "1.0 to 10.0" includes all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein includes all lower numerical limitations subsumed therein, and any minimum numerical limitation recited in this specification includes all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

As described above, to minimize discharge caused by dark current of a low-voltage battery, a battery management system BMS is provided with a dark current blocking element that is connected to a circuit through which current is supplied from the low-voltage battery to electrical loads to block the dark current. Typically, the dark current blocking element is implemented as a field effect transistor (FET) and operates to block the dark current of the battery through its turn-off (open) operation.

Meanwhile, when a short-based failure of the FET (e.g., FET destruction due to short-circuiting of a body diode) occurs due to a defect of the FET (i.e., dark current blocking element) itself or an abnormality in the voltage applied to the dark current blocking element, a short-circuit state between a drain terminal and a source terminal of the FET cannot be controlled to an open state, and therefore the dark current blocking element loses its dark current blocking function and the dark current increases. Since the short-based failure of the FET does not affect the normal start up and operation of the BMS, the dark current caused by the short-based failure of the FET cannot be detected unless the increase in the dark current is monitored separately, which may result in the discharge of the low-voltage battery, and thus the low-voltage battery may be completely discharged.

Generally, since the magnitude of dark current is in the range of several hundred uA or less, to directly detect the dark current, a high-power amplifier with a very high amplification ratio should be used, or a shunt resistor with a high resistance value should be applied to a circuit through which the dark current flows to implement a high current amplification ratio. However, since the high-power amplifier amplifies even noise components along a current circuit, it is difficult to accurately determine whether a sensed value corresponds to the dark current. In addition, when a shunt resistor with a high resistance value is applied to a circuit through which the dark current flows, the power efficiency of the BMS decreases as the power consumed in the shunt resistor increases, causing the lifetime of the BMS to be shortened due to the heat generated in the shunt resistor.

The present embodiment presents a circuit topology capable of detecting an increase in dark current due to loss of the dark current blocking function of a dark current blocking element without applying a high-power amplifier or a shunt resistor with a high resistance value, which is described in detail below.

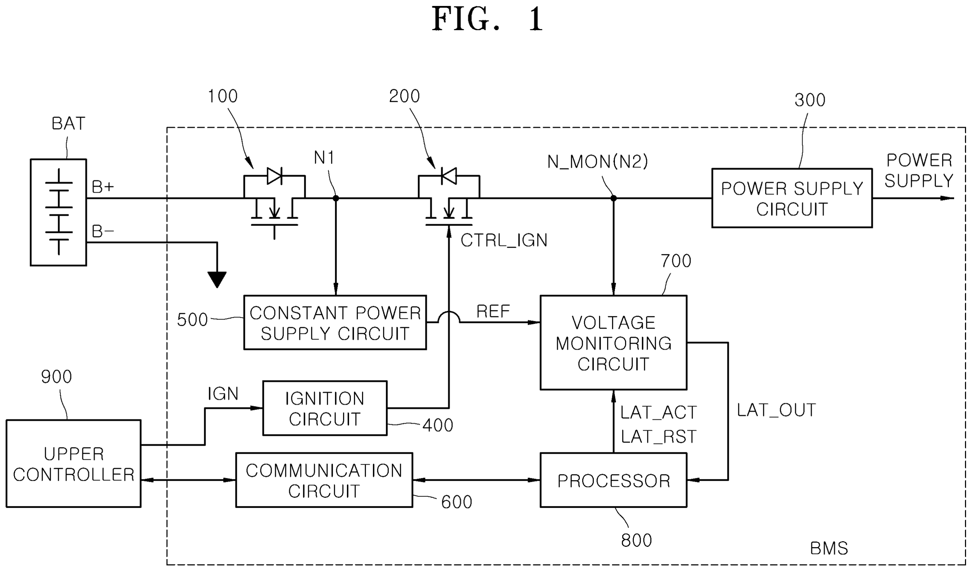

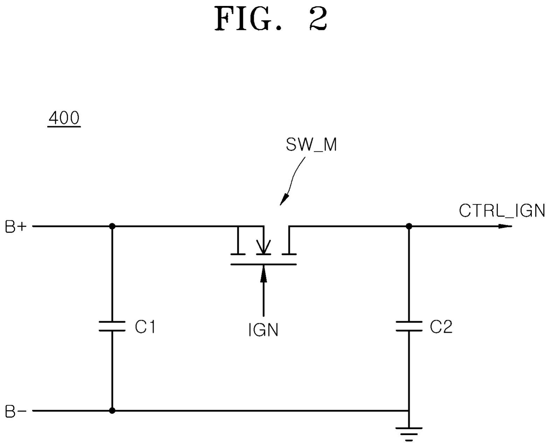

FIG. 1 is a block diagram of a dark current detection apparatus according to one embodiment of the present disclosure, and FIG. 2 is a circuit diagram of an ignition circuit of the dark current detection apparatus according to one embodiment of the present disclosure.

Referring to FIG. 1, the dark current detection apparatus of the present embodiment may include a reverse polarity prevention element 100, a dark current blocking element 200, a power supply circuit 300, an ignition circuit 400, a constant power supply circuit 500, a communication circuit 600, a voltage monitoring circuit 700, and a processor 800, and may be implemented as a BMS as illustrated in FIG. 1. In addition, the dark current detection apparatus of the present embodiment may constitute a battery pack together with a battery BAT.

First, the battery BAT may correspond to a low-voltage battery (e.g., a lead-acid battery) for supplying operating power to an electrical load applied to a vehicle (e.g., an audio-video-navigation (AVN) device, head-up display (HUD), lamp device, air conditioning device, wiper device, or the like). As another embodiment, the battery BAT may correspond to a high-voltage battery (e.g., a lithium-ion battery) for supplying operating power to a drive system (e.g., an inverter and a driving motor) applied to an electric vehicle. The load indicated below may mean an electrical load of a vehicle operating based on the low-voltage power supplied from a low-voltage battery, or a vehicle drive system operating based on the high-voltage power supplied from a high-voltage battery. The battery BAT may include a plurality of battery cells, or may include a plurality of battery modules configured by connecting a plurality of battery cells in series or in parallel.

The reverse polarity prevention element 100 may be implemented as a FET (e.g., an N-channel FET) to prevent reverse polarity connection between the battery BAT and the BMS (e.g., a state in which a positive terminal of the battery BAT is connected to a ground terminal of the BMS and a ground terminal of the battery BAT is connected to a positive terminal of the BMS). A source terminal of the reverse polarity prevention element 100 may be connected to the battery BAT, a drain terminal may be connected to a drain terminal of the dark current blocking element 200 at a node N1 of FIG. 1, and a gate terminal may be connected to the processor 800 described below. When the reverse polarity is connected between the battery BAT and the BMS, the reverse polarity prevention element 100 is controlled to be turned off, and when the battery BAT and the BMS are normally connected, the reverse polarity prevention element 100 may be controlled to be maintained in a turned-on state (when the battery BAT and the BMS are normally connected, the reverse polarity prevention element 100 may be maintained in a turned-on state regardless of whether an operation mode of the BMS is a wake-up mode or a shut-down mode). The turn-on and turn-off of the reverse polarity prevention element 100 may be controlled by the processor 800 described below. The reverse polarity prevention element 100 may be omitted in the embodiment depending on the specifications of the BMS and the battery pack and a designer's intention.

The dark current blocking element 200 may be implemented as a FET (e.g., an N-channel FET) connected to a circuit through which current drawn from the battery BAT is supplied to a load to interrupt the flow of current. In the wake-up mode of the BMS, the dark current blocking element 200 is turned on (closed) so that the load may be normally driven by the current drawn from the battery BAT (this has the same meaning as that the operating power of the load is generated by the power supply circuit 300 described below based on the battery power, and the load is driven by the generated operating power), and in the shut-down mode of the BMS, the dark current blocking element 200 is turned off (open) so that the dark current drawn from the battery BAT may be blocked. That is, the dark current blocking element 200 may operate as a driving switch to drive the load in the wake-up mode of the BMS, and the dark current blocking element 200 may operate as a dark current blocking switch to block the dark current in the shut-down mode of the BMS.

As illustrated in FIG. 1, the dark current blocking element 200 may include a first terminal corresponding to an input terminal of the battery BAT, and the dark current blocking element 200 may include a second terminal corresponding to an output terminal of the battery BAT. The dark current blocking element 200 may also include a third terminal that functions as a terminal controlling whether electrical conduction occurs between the first and second terminals. For example, the first terminal may be the drain terminal connected to the reverse polarity prevention element 100, the second terminal may be a source terminal connected to the power supply circuit 300 described below at a node N2 of FIG. 1, and the third terminal may be a gate terminal. The turn-on and turn-off of the dark current blocking element 200 may be controlled by inputting a control signal CTRL_IGN output from the ignition circuit 400 described below to the third terminal (gate terminal).

The power supply circuit 300 may operate to generate and supply the operating power of an internal integrated circuit (IC) of the BMS and the operating power of the load based on the battery power supplied from the battery BAT while the dark current blocking element 200 is turned on and electrically connected to the battery BAT, and the processor 800 described below may also perform various operations for controlling the operation of the internal IC of the BMS based on the operating power supplied from the power supply circuit 300 in the wake-up mode of the BMS. The power supply circuit 300 may be implemented as a converter or a power management integrated circuit (PMIC) that converts the battery power into operating power (internal power or external power) used inside or outside the BMS.

The ignition circuit 400 may control the turn-on and turn-off of the dark current blocking element 200 described above according to an ignition signal IGN applied from an upper controller 900 (e.g., Electronic Control Unit (ECU) of a vehicle) of the dark current detection apparatus (i.e., BMS) of the present embodiment, thereby controlling the electrical connection and disconnection between the battery BAT and the power supply circuit 300. To control the turn-on and turn-off of the dark current blocking element 200, the signal output from the ignition circuit 400 is defined as the control signal CTRL_IGN.

As illustrated in FIG. 2, the ignition circuit 400 may include a main switch SW_M for blocking an electrical connection between the battery BAT and the control signal output terminal, a noise removal capacitor for removing noise of the battery power applied from the battery BAT, and an output capacitor for outputting the battery power, and the main switch SW_M may be implemented as a FET (e.g., an N-channel FET). In the wake-up mode of the BMS, a state in which the ignition signal IGN (at a high level) is applied from the upper controller 900 to the ignition circuit 400 is maintained, and accordingly, the main switch SW_M of the ignition circuit 400 is turned on, and the control signal CTRL_IGN at a high-level (battery voltage level) is output through the output terminal of the control signal and input to the third terminal of the dark current blocking element 200, and thus the dark current blocking element 200 may be turned on (deactivation of the dark current blocking operation). When the BMS transitions from the wake-up mode to the shut-down mode, the ignition signal IGN is not applied from the upper controller 900 to the ignition circuit 400, and accordingly, the main switch SW_M of the ignition circuit 400 is turned off, and the control signal CTRL_IGN at a low level (ground level) is output through the output terminal of the control signal and input to the third terminal of the dark current blocking element 200, and thus the dark current blocking element 200 may be turned off (activation of the dark current blocking operation). That is, the ignition circuit 400 may be configured to control the activation of the dark current blocking operation of the dark current blocking element 200 through the control signal CTRL_IGN.

The constant power supply circuit 500 may be configured to generate constant power for the BMS based on the power supplied from the battery BAT. As illustrated in FIG. 1, the constant power supply circuit 500 is configured to constantly receive the battery power, and based on the input battery power, it may generate constant power for the constant operation of the BMS internal circuits (e.g., a real time clock (RTC) circuit or air pressure sensor, etc.) that require the constant power, the power monitoring circuit described below, the communication circuit 600, and the processor 800. The dark current detection operation in the shut-down mode of the BMS described below may be implemented by the constant power supplied by the constant power supply circuit 500. Additionally, the constant power supply circuit 500 may be configured to generate a reference voltage REF required for dark current detection (described below). The constant power supply circuit 500 may be implemented with a low drop-output (LDO) regulator.

The communication circuit 600 may be implemented as a CAN transceiver for communication between the processor 800 and the upper controller 900, and as described below, the processor 800 may notify the upper controller 900 of the occurrence of dark current through the communication circuit 600.

The voltage monitoring circuit 700 may output a signal having a variable magnitude according to the voltage of monitoring node N_MON (or N2) connected to the dark current blocking element 200, and the voltage monitoring circuit 700 functions as a dark current sensing circuit that senses the dark current drawn from the battery BAT. Here, the monitoring node N_MON may correspond to the second terminal of the dark current blocking element 200 (the output terminal of the dark current blocking element 200).

In the normal state where a short-based failure (a state in which a short circuit occurs between the first and second terminals) does not occur in the dark current blocking element 200, the dark current blocking element 200 is turned off in the shut-down mode of the BMS, and accordingly, the voltage at the second terminal of the dark current blocking element 200 is formed as 0 V. When a short-based failure of the dark current blocking element 200 occurs, the dark current blocking element 200 loses its dark current blocking function, and therefore the dark current flows from the battery BAT to the power supply circuit 300, resulting in the voltage at the second terminal of the dark current blocking element 200 increasing to reach a battery voltage level (e.g., 12 V).

Accordingly, the voltage monitoring circuit 700 of the present embodiment may be configured to sense the dark current caused by the loss of the dark current blocking function of the dark current blocking element 200 by monitoring the voltage formed at the second terminal having a variable magnitude according to whether the short-based failure occurs in the dark current blocking element 200.

For convenience of description, a node to be monitored for voltage is defined as the monitoring node N_MON, the voltage of the monitoring node N_MON is defined as a monitoring voltage V_MON, and an output signal of the voltage monitoring circuit 700 is defined as a voltage monitoring signal LAT_OUT.

The processor 800 may activate the voltage monitoring circuit 700 through an activation signal LAT_ACT in the shut-down mode of the BMS, and determine whether the dark current occurs based on the voltage monitoring signal LAT_OUT output from the activated voltage monitoring circuit 700. The processor 800 may be implemented as a central processing unit (CPU) or a system on chip (SoC), may control multiple hardware or software components by running an operating system or application, and may perform various data processing and calculations. The processor 800 may be configured to execute one or more instructions stored in memory (not shown) and store the execution result data in the memory. The processor 800 may correspond to a micro controller unit (MCU) or analog front-end IC (AFE IC) of the BMS.

As described above, in the shut-down mode of the BMS, the dark current blocking element 200 is controlled to be turned off by the control signal CTRL_IGN of the ignition circuit 400 to perform the dark current blocking function, and the load is not driven as the dark current blocking element 200 is turned off. In addition, to sense the dark current in the shut-down mode of the BMS, the voltage monitoring circuit 700 may be activated by the activation signal LAT_ACT output from the processor 800. "A state in which the load is not driven, the dark current blocking element 200 is controlled to block the dark current, and the voltage monitoring circuit 700 is activated through the activation signal LAT_ACT" may be defined as the dark current detection mode, and in this disclosure, the dark current detection mode has the same meaning as the shut-down mode of the BMS. Hereinafter, it is expressed in a uniform manner as the shut-down mode of the BMS.

In the shut-down mode of the BMS, the voltage monitoring circuit 700 may be configured to output a high-level voltage monitoring signal LAT_OUT in response to an increase in the monitoring voltage V_MON. When the high-level voltage monitoring signal LAT_OUT is input from the voltage monitoring circuit 700, the processor 800 determines that dark current has occurred according to the loss of the dark current blocking function of the dark current blocking element 200, and may notify the upper controller 900 of the occurrence of dark current through the communication circuit 600.

Two embodiments may be presented to implement the operation of the voltage monitoring circuit 700 as described above, and each embodiment is described in detail below.

### 1. First embodiment

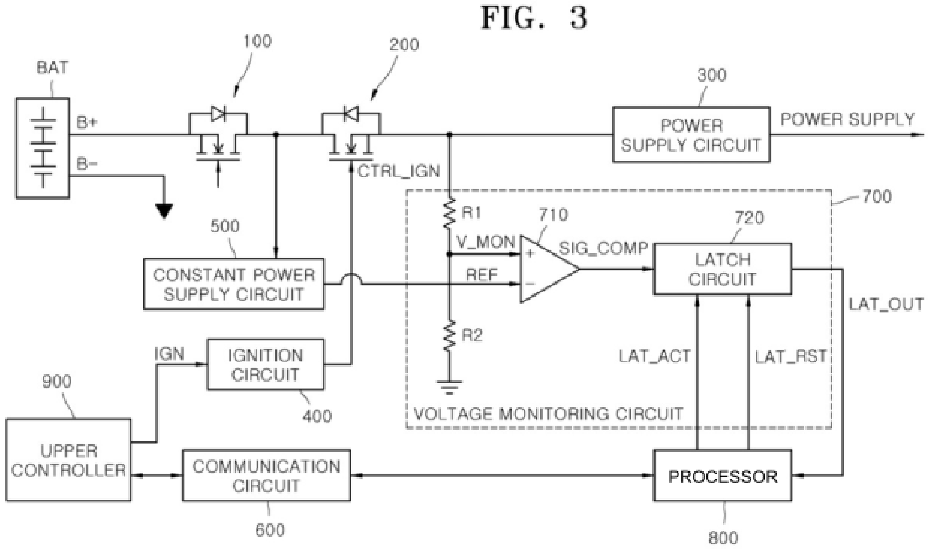

FIG. 3 is a circuit diagram of a dark current detection apparatus according to a first embodiment of the present disclosure.

Referring to FIG. 3, the voltage monitoring circuit 700 of the first embodiment may include a comparator 710 and a latch circuit 720. The operation of the comparator 710 and the latch circuit 720 below assumes that the BMS is in the shut-down mode. The signal applied in the first embodiment may follow either an active-high mode or an active-low mode.

The comparator 710 may compare the monitoring voltage V_MON in the monitoring node N_MON with the reference voltage REF generated by the constant power supply circuit 500 and output a comparison signal SIG_COMP according to a comparison result. The comparator 710 may be implemented as a conventional OP-AMP, and the constant power generated by the constant power supply circuit 500 may be utilized as its operating voltage. Here, the reference voltage REF means a reference value compared with the monitoring voltage V_MON to sense the dark current due to the occurrence of a short-based failure of the dark current blocking element 200, and the reference voltage REF value may be predefined as a value less than a saturation value (e.g., a battery voltage) of the voltage formed at the monitoring node N_MON when the short-based failure of the dark current blocking element 200 occurs. The comparator 710 may be configured to output a low-level comparison signal SIG_COMP when the monitoring voltage V_MON is less than the reference voltage REF and to output a high-level comparison signal SIG_COMP when the monitoring voltage V_MON is greater than or equal to the reference voltage REF.

Meanwhile, as illustrated in FIG. 3, an embodiment may be provided in which the monitoring voltage V_MON is voltage-divided by first and second resistors R1 and R2, and the divided voltage is input to the comparator 710. The monitoring voltage V_MON and the divided voltage differ only in the degree of scale according to the first and second resistors R1 and R2, and since both function as parameters indicating whether dark current occurs due to the occurrence of a short-based failure of the dark current blocking element 200, the monitoring voltage V_MON and the divided voltage are unified and expressed as a monitoring voltage V_MON in this embodiment.

The latch circuit 720 may output a voltage monitoring signal LAT_OUT having a variable magnitude according to the comparison signal SIG_COMP output from the comparator 710 in an activated state. The 'variable magnitude' described above may mean a magnitude that is dichotomized into a high level or a low level. The activation of the latch circuit 720 is controlled by the activation signal LAT_ACT output from the processor 800, and the reset may also be controlled by a reset signal LAT_RST output from the processor 800. In the first embodiment, the latch circuit 720 may be implemented as a gated SR latch having an S input to which the comparison signal SIG_COMP is input, an R input to which the reset signal LAT_RST is input, a C input to which the activation signal LAT_ACT is input, and a Q output from which the voltage monitoring signal LAT_OUT is output.

When a low-level comparison signal SIG_COMP is output from the comparator 710, the latch circuit 720 may be configured to output a low-level voltage monitoring signal LAT_OUT (corresponding to a case in which dark current does not occur), and when a high-level comparison signal SIG_COMP is output from the comparator 710, the latch circuit 720 may be configured to output a high-level voltage monitoring signal LAT_OUT (corresponding to a case in which dark current occurs). As long as the reset signal LAT_RST from the processor 800 is not input to the latch circuit 720, the high-level voltage monitoring signal LAT_OUT is latched and continuously transmitted to the processor 800. Therefore, even when the monitoring voltage V_MON decreases below the reference voltage REF after the dark current occurs and the level of the comparison signal SIG_COMP transitions to a low level, the voltage monitoring signal LAT_OUT may be configured to be maintained at a high level so that the determination of the occurrence of the dark current is not reversed.

When it is determined that the dark current has occurred through the voltage monitoring signal LAT_OUT, the processor 800 may notify the upper controller 900 of the occurrence of the dark current, and the upper controller 900 may perform appropriate follow-up actions, such as notifying an external server provided externally to support a vehicle management service of the occurrence of the dark current, or notifying a user terminal of the occurrence of the dark current through a communication link established with a user terminal possessed by the user. Along with the action of notifying the occurrence of dark current, the processor 800 may reset the latch circuit 720 through the reset signal LAT_RST.

Meanwhile, in the wake-up mode of the BMS, the processor 800 may deactivate the latch circuit 720 to prevent the voltage monitoring circuit 700 from affecting the operation of the BMS.

### 2. Second embodiment

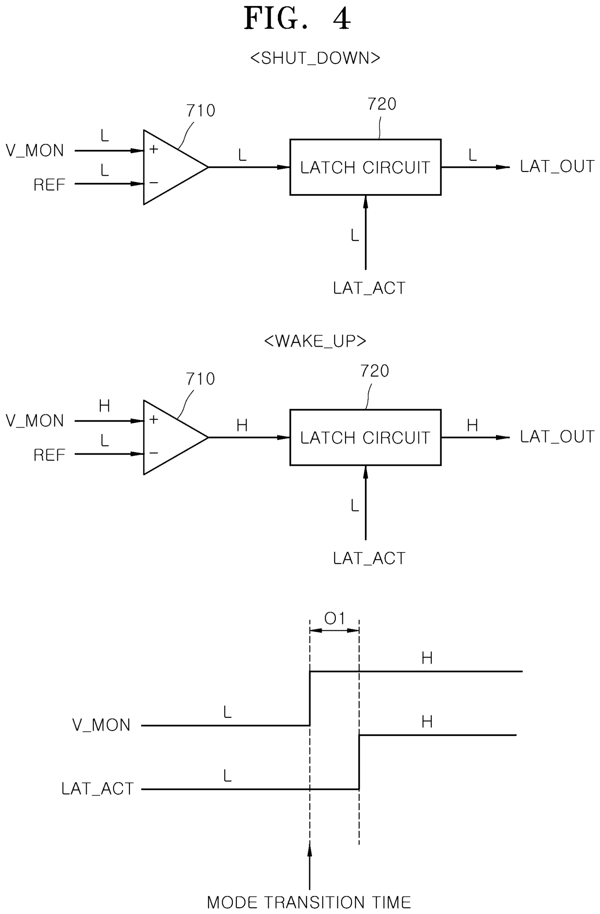

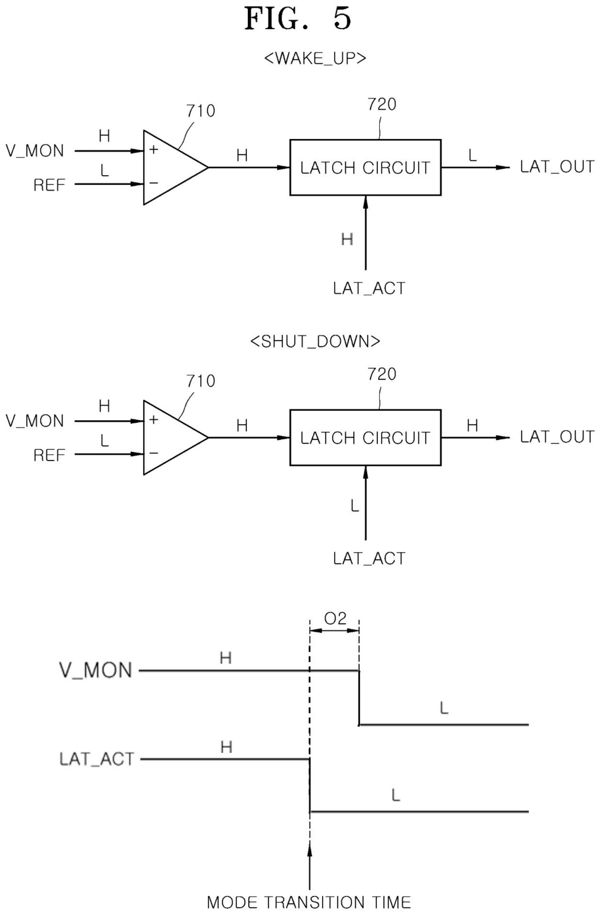

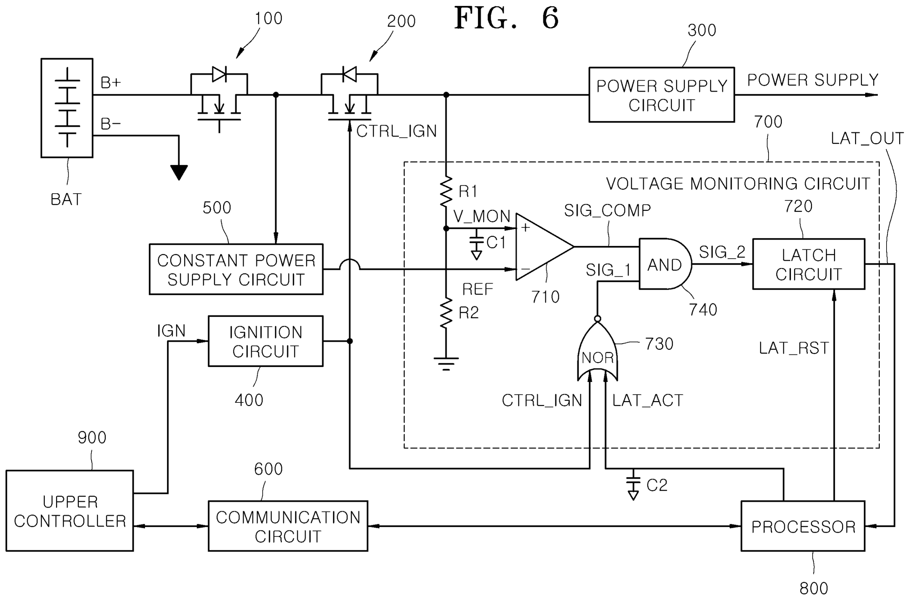

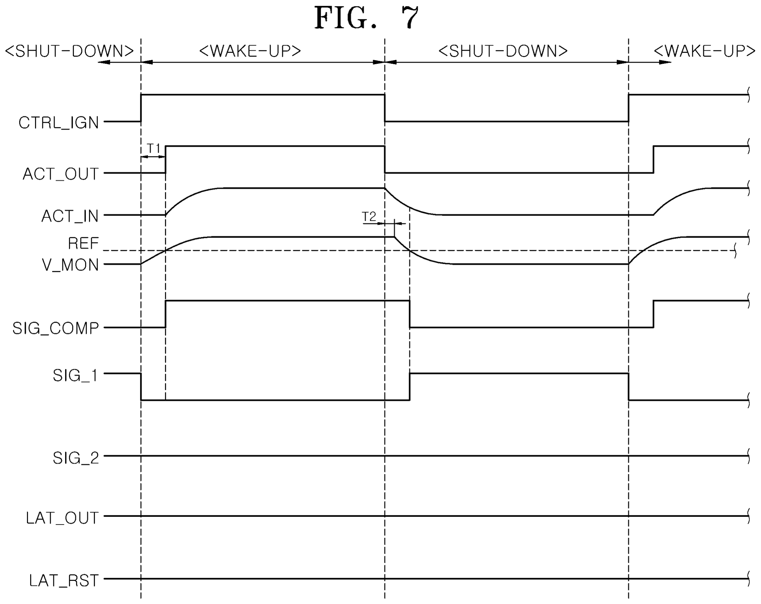

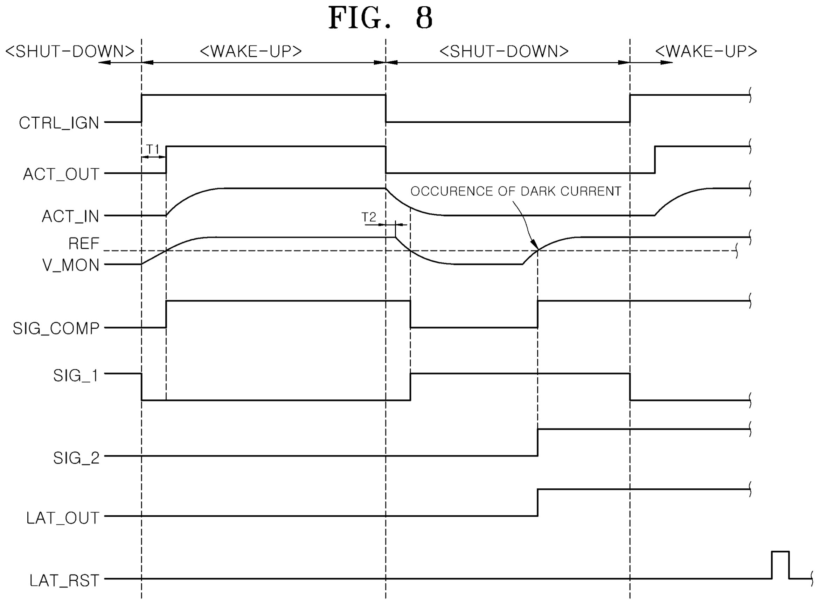

FIGS. 4 and 5 are examples for describing an offset between a level of the monitoring voltage V_MON and a level of the activation signal LAT_ACT that occurs in the dark current detection apparatus according to the first embodiment of the present disclosure, and FIG. 6 is a circuit diagram of a dark current detection apparatus according to a second embodiment of the present disclosure, FIGS. 7 and 8 are timing diagrams for describing the operation of the dark current detection apparatus according to the second embodiment of the present disclosure.

Before going into a specific description of the second embodiment, the "abnormality of the voltage monitoring signal LAT_OUT caused by the offset between the level of the monitoring voltage V_MON and the level of the activation signal LAT_ACT" that may appear in the first embodiment described above will be described with reference to FIGS. 4 and 5. In order to help understand the embodiment, the activation signal LAT_ACT follows an active-low mode, and the remaining signals including the control signal CTRL_IGN follow an active-high mode as an example.

FIG. 4 shows an example of the operation of the voltage monitoring circuit 700 of the first embodiment when transitioning from the shut-down mode of the BMS to the wake-up mode.

In the shut-down mode of BMS, the latch circuit 720 is activated by a low-level activation signal LAT_ACT (active low). In addition, the monitoring voltage V_MON is less than the reference voltage REF, and thus a low-level comparison signal SIG_COMP is output to the latch circuit 720. Accordingly, the voltage monitoring signal LAT_OUT is formed at a low level, and it is determined that no dark current occurs.

When the BMS transitions from the shut-down mode to the wake-up mode, the activation signal LAT_ACT output from the processor 800 must transition to a high level. However, as illustrated in FIG. 4, due to factors such as the latency of the signal interface of the BMS, the activation signal LAT_ACT is maintained at a low level even though the BMS has transitioned from the shut-down mode to the wake-up mode, and accordingly, the latch circuit 720, which should be deactivated, is maintained in an activated state. Meanwhile, as the BMS transitions from the shut-down mode to the wake-up mode, the dark current blocking element 200 is turned on, the monitoring voltage V_MON of the monitoring node N_MON transitions to a high level (i.e., the battery voltage level), and therefore the comparison signal SIG_COMP output from the comparator 710 is formed at a high level. As a result, the latch circuit 720, which remains activated when the BMS enters the wake-up mode, receives the high-level comparison signal SIG_COMP and outputs a high-level voltage monitoring signal LAT_OUT, and the processor 800 incorrectly determines that dark current has occurred based on the high-level voltage monitoring signal LAT_OUT even though the dark current is not currently occurring.

Next, FIG. 5 shows an example of the operation of the voltage monitoring circuit 700 of the first embodiment when the BMS transitions from the wake-up mode to the shut-down mode.

In the wake-up mode of the BMS, the level of the monitoring voltage V_MON is formed as the battery voltage level, and a high-level comparison signal SIG_COMP is output to the latch circuit 720. However, the latch circuit 720 is deactivated by the high-level activation signal LAT_ACT, and thus the dark current sensing operation by the voltage monitoring circuit 700 is not performed.

When the BMS transitions from the wake-up mode to the shut-down mode, the dark current block circuit is turned off, and thus the monitoring voltage V_MON should transition to a low level (ground level). However, as shown in FIG. 5, due to causes such as a parasitic capacitor formed parasitically at the monitoring node N_MON, the monitoring voltage V_MON is maintained at a high level even though the BMS has transitioned from the wake-up mode to the shut-down mode, and accordingly, the comparison signal SIG_COMP output from the comparator 710 is also maintained at a high level. Meanwhile, as the BMS transitions from the wake-up mode to the shut-down mode, the activation signal LAT_ACT output from the processor 800 transitions to a low level, thereby activating the latch circuit 720. As a result, when the BMS enters the shut-down mode, the activated latch circuit 720 receives the high-level comparison signal SIG_COMP and outputs a high-level voltage monitoring signal LAT_OUT, and the processor 800 incorrectly determines that dark current has occurred based on the high-level voltage monitoring signal LAT_OUT even though the dark current is not currently occurring.

That is, as illustrated in FIGS. 4 and 5, an offset O1 and O2 may be formed between the level transition time of the monitoring voltage V_MON and the level transition time of the activation signal LAT_ACT, based on the time point at which the BMS transitions from the shut-down mode to the wake-up mode and the time point at which the BMS transitions from the wake-up mode to the shut-down mode. This offset may be a factor that causes the processor 800 to incorrectly determine that dark current has occurred even though no dark current is not currently occurring.

In the second embodiment, a compensation circuit (C1, C2, 730, and 740) is employed to compensate for an abnormality of the voltage monitoring signal LAT_OUT caused by an offset between the level transition time of the monitoring voltage V_MON and the level transition time of the activation signal LAT_ACT, at the time point at which the BMS transitions from the shut-down mode to the wake-up mode (corresponding to the end time of the dark current detection mode described in the claims of the present disclosure) and the time point at which the BMS transitions from the wake-up mode to the shut-down mode (corresponding to the entry time of the dark current detection mode described in the claims of the present disclosure). That is, the voltage monitoring circuit 700 of the second embodiment may further include the compensation circuit (C1, C2, 730, and 740), as well as the comparator 710 and the latch circuit 720.

Specifically, as illustrated in FIG. 6, the compensation circuit (C1, C2, 730, and 740) may include first and second delay elements C1 and C2, a NOR gate 730, and an AND gate 740.

The first delay element C1 may be configured to delay the level transition time of the monitoring voltage V_MON to compensate for an abnormality in the voltage monitoring signal LAT_OUT caused by an offset between the level transition time of the monitoring voltage V_MON and the level transition time of the activation signal LAT_ACT, based on the time point at which the BMS transitions from the shut-down mode to the wake-up mode. The first delay element C1 is configured to remove the offset illustrated in FIG. 4 and may be implemented as a capacitor connected to the circuit through which the monitoring voltage V_MON is input to the comparator 710. Accordingly, the level transition time of the monitoring voltage V_MON when the BMS transitions from the shut-down mode to the wake-up mode may be delayed by the first delay element C1.

The second delay element C2 may be configured to delay the level transition time of the activation signal LAT_ACT in order to compensate for an abnormality in the voltage monitoring signal LAT_OUT caused by an offset between the level transition time of the monitoring voltage V_MON and the level transition time of the activation signal LAT_ACT, based on the time point at which the BMS transitions from the wake-up mode to the shut-down mode. The second delay element C2 is configured to remove the offset illustrated in FIG. 5, and may be implemented as a capacitor connected to the circuit through which the activation signal LAT_ACT is input to the NOR gate 730 described below. Accordingly, the level transition time of the activation signal LAT_ACT when the BMS transitions from the wake-up mode to the shut-down mode may be delayed by the second delay element C2.

The NOR gate 730 may be configured to output a first intermediate signal SIG_1 through a NOR operation on the control signal CTRL_IGN output from the ignition circuit 400 and the activation signal LAT_ACT output from the processor 800. Additionally, the AND gate 740 may be configured to output a second intermediate signal SIG_2 to the latch circuit 720 through an AND operation on the comparison signal SIG_COMP output from the comparator 710 and the first intermediate signal SIG_1 output from the NOR gate 730. Accordingly, the latch circuit 720 may output a voltage monitoring signal LAT_OUT having a variable magnitude to the processor 800 according to the second intermediate signal SIG_2 output from the AND gate 740. As described above, the ' variable magnitude' may mean a magnitude that is dichotomized into a high level or a low level. In the second embodiment, the latch circuit 720 may be implemented as an SR latch having an S input to which the second intermediate signal SIG_2 is input, an R input to which the reset signal LAT_RST is input, and a Q output from which the voltage monitoring signal LAT_OUT is output.

FIG. 7 is a timing diagram showing the level change of each signal according to the time when no dark current occurs (i.e., when the dark current blocking function of the dark current blocking element 200 is not lost). In FIG. 7, the activation signal LAT_ACT follows an active-low mode, and the remaining signals including the control signal CTRL_IGN follow an active-high mode (in FIG. 7, ACT_OUT means an activation signal output from the processor 800, and ACT_IN means an activation signal input to the NOR gate 730 through the second delay element C2).

When focusing on the input and output of the latch circuit 720, a low-level second intermediate signal SIG_2 is input to the latch circuit 720 during the entire period of the wake-up mode and the shut-down mode of BMS, and thus a low-level voltage monitoring signal LAT_OUT is output, which means that the dark current sensing operation by the voltage monitoring circuit 700 is not performed.

When the BMS transitions from the shut-down mode to the wake-up mode, even when the activation signal LAT_ACT output from the processor 800 is maintained at a low level for a time T1, the level transition time of the monitoring voltage V_MON is delayed by the first delay element C1, which may prevent the dark current from being incorrectly determined as occurring due to the high-level voltage monitoring signal LAT_OUT, as described in FIG. 4. In addition, when the BMS transitions from the wake-up mode to the shut-down mode, even when the monitoring voltage V_MON is maintained at a high level for a time T2, the level transition time of the activation signal LAT_ACT is delayed by the second delay element C2, which may prevent the dark current from being incorrectly determined as occurring due to the high-level voltage monitoring signal LAT_OUT, as described in FIG. 5.

FIG. 8 is a timing diagram showing the level change of each signal according to the time when dark current occurs (i.e., when the dark current blocking function of the dark current blocking element 200 is lost). The activation signal LAT_ACT follows the active-low mode, and the remaining signals including the control signal CTRL_IGN follow the active-high mode (in FIG. 8, ACT_OUT means an activation signal output from the processor 800, and ACT_IN means an activation signal input to the NOR gate 730 through the second delay element C2).

In the shut-down mode of the BMS, a low-level control signal CTRL_IGN and a low-level activation signal ACT_IN are input to the NOR gate 730, and a high-level first intermediate signal SIG_1 is output. In this case, as illustrated in FIG. 8, when dark current occurs and the monitoring voltage V_MON rises and becomes greater than the reference voltage REF, a high-level comparison signal SIG_COMP is output from the comparator 710. The high-level comparison signal SIG_COMP and the high-level first intermediate signal SIG_1 are input to the AND gate 740, and a high-level second intermediate signal SIG_2 is output to the latch circuit 720, and accordingly, a high-level voltage monitoring signal LAT_OUT is output from the latch circuit 720, so that the occurrence of dark current may be detected. The high-level voltage monitoring signal LAT_OUT output from the latch circuit 720 is maintained until the reset signal (LAT_RST) is input to the latch circuit 720 from the processor 800.

In this way, according to the present disclosure, the discharge of the battery may be prevented in advance by detecting an increase in dark current due to the loss of the dark current blocking function of the dark current blocking element 200 and notifying the upper controller (e.g., vehicle ECU) so that the user can take follow-up measures.

The implementations described herein may be implemented as, for example, a method or process, an apparatus, a software program, a data stream or a signal. Even when discussed in the context of only a single form of implementation (e.g., discussed only as a method), the implementation of the features discussed may also be implemented in other forms (e.g., as an apparatus or a program). The apparatus may be implemented as suitable hardware, software, firmware, and the like. The method may be implemented in a device such as the processor, which generally refers to a processing device including, for example, a computer, a microprocessor, an integrated circuit, or a programmable logic device. The processor also includes communication devices such as computers, cell phones, personal digital assistants ("PDAs"), and other devices that facilitate communication of information between end-users.

According to the present disclosure, the discharge of a battery can be prevented in advance by detecting an increase in dark current due to the loss of the dark current blocking function of a dark current blocking element and notifying an upper controller (e.g., vehicle ECU) so that a user can take follow-up measures.

However, effects that can be achieved through the present disclosure are not limited to the above-described effects and other effects that are not described may be clearly understood by those skilled in the art from the detailed descriptions.

## Claims

1. A dark current detection apparatus comprising:
a voltage monitoring circuit (700) that outputs a voltage monitoring signal having a variable magnitude, the variable magnitude varying according to a monitoring voltage of a monitoring node connected to a dark current blocking element (200),
wherein the dark current blocking element (200) is connected to a circuit (300, 500, 600) through which current drawn from a battery is supplied to a load; and
wherein the dark current blocking element (200) is configured to block a dark current drawn from the battery in a state in which the load is not driven; and
a processor (800) that activates the voltage monitoring circuit (700) through an activation signal, wherein the processor (800) determines whether the dark current occurs based on the voltage monitoring signal output from the activated voltage monitoring circuit (700).

2. The dark current detection apparatus of claim 1, wherein:
the dark current blocking element (200) includes a first terminal and a second terminal, the first terminal corresponding to an input terminal of the battery and the second terminal corresponding to an output terminal of the battery; and
the monitoring node is a node connected to the second terminal.

3. The dark current detection apparatus of claim 2, wherein:
in a dark current detection mode where the load is not driven:
the dark current blocking element (200) blocks the dark current,
the voltage monitoring circuit (700) is activated through the activation signal, and
the voltage monitoring circuit (700) outputs a high-level voltage monitoring signal in response to an increase in the monitoring voltage; and
the processor (800) determines that the dark current occurs due to loss of a dark current blocking function of the dark current blocking element (200) when the high-level voltage monitoring signal is input from the voltage monitoring circuit (700).

4. The dark current detection apparatus of claim 3, wherein the voltage monitoring circuit (700) further includes:
a comparator (710) that compares the monitoring voltage with a predefined reference voltage and outputs a comparison signal according to a comparison result; and
a latch circuit (720) that outputs a voltage monitoring signal having a variable magnitude according to the comparison signal output from the comparator (710).

5. The dark current detection apparatus of claim 4, wherein:
in the dark current detection mode,
the comparator (710) outputs a high-level comparison signal when the monitoring voltage is greater than or equal to the predefined reference voltage; and
the latch circuit (720) outputs a latched high-level voltage monitoring signal in response to the high-level comparison signal being output from the comparator (710).

6. The dark current detection apparatus of claim 4 or 5, wherein the voltage monitoring circuit (700) further includes:
a compensation circuit that compensates for an abnormality of the voltage monitoring signal caused by an offset between a level transition time of the monitoring voltage and a level transition time of the activation signal based on an end time or entry time of the dark current detection mode.

7. The dark current detection apparatus of claim 6, wherein the compensation circuit includes a delay element that delays the level transition time of the monitoring voltage in order to compensate for the abnormality of the voltage monitoring signal caused by the offset between the level transition time of the monitoring voltage and the level transition time of the activation signal based on the end time of the dark current detection mode.

8. The dark current detection apparatus of claim 7, wherein the compensation circuit further includes a second delay element that delays the level transition time of the activation signal in order to compensate for the abnormality of the voltage monitoring signal caused by the offset between the level transition time of the monitoring voltage and the level transition time of the activation signal based on the entry time of the dark current detection mode.

9. The dark current detection apparatus of claim 8, further comprising an ignition circuit (400) that controls activation of a dark current blocking operation of the dark current blocking element (200) through a control signal,
wherein the compensation circuit further includes a NOR gate (730) that outputs a first intermediate signal through a NOR operation on the control signal and the activation signal, and an AND gate (740) that outputs a second intermediate signal through an AND operation on the first intermediate signal and the comparison signal output from the comparator (710).

10. The dark current detection apparatus of claim 9, wherein the latch circuit (720) outputs the voltage monitoring signal having a variable magnitude according to the second intermediate signal.

11. The dark current detection apparatus of claim 9 or 10, wherein the control signal follows an active-high mode, and the activation signal follows an active-low mode.

12. The dark current detection apparatus of claim 11, wherein:
in the dark current detection mode, when the monitoring voltage is greater than or equal to the predefined reference voltage:
a low-level control signal and a low-level activation signal are input to the NOR gate (730), and a high-level first intermediate signal is output;
a high-level comparison signal is output from the comparator (710);
the high-level comparison signal and the high-level first intermediate signal are input to the AND gate (740); and
a high-level second intermediate signal is output; and
a high-level voltage monitoring signal is output from the latch circuit (720) and transmitted to the processor (800).

13. The dark current detection apparatus of any one of the claims 4 to 12, wherein when determining that the dark current has occurred through the voltage monitoring signal, the processor (800) notifies an upper controller (900) of the dark current and resets the latch circuit (720) through a reset signal.

14. A battery management system, BMS, comprising:
a dark current blocking element (200) connected to a circuit (300, 500, 600) through which current drawn from a battery is supplied to a load, the dark current blocking element (200) configured to interrupt flow of the current and to block a dark current drawn from the battery in a shut-down mode of the BMS;
a voltage monitoring circuit (700) that outputs a voltage monitoring signal having a variable magnitude according to a monitoring voltage of a monitoring node connected to the dark current blocking element (200); and
a processor (800) that activates the voltage monitoring circuit (700) through an activation signal in the shut-down mode of the BMS, wherein the processor (800) determines whether the dark current occurs based on the voltage monitoring signal output from the activated voltage monitoring circuit (700).

15. A battery pack comprising:
a battery provided to supply operating power to a BMS;
a dark current blocking element (200) connected to a circuit (300, 500, 600) through which current drawn from the battery is supplied to a load, the dark current blocking element (200) configured to interrupt flow of the current and to block a dark current drawn from the battery in a shut-down mode of the BMS;
a voltage monitoring circuit (700) that outputs a voltage monitoring signal having a variable magnitude according to a monitoring voltage of a monitoring node connected to the dark current blocking element (200); and
a processor (800) that activates the voltage monitoring circuit (700) through an activation signal in the shut-down mode of the BMS and determines whether the dark current occurs based on the voltage monitoring signal output from the activated voltage monitoring circuit (700).
